# FASCICULE DE BREVET EUROPEEN

(11) **EP 0 549 465 B1**
(45) Date de publication et mention de la délivrance du brevet: **03.01.1996**
(21) Numéro de dépôt: 92403530.6
(22) Date de dépôt: 22.12.1992
(51) Int. Cl.: H01S 3/25

(54) **Laser semi-conducteur avec entrée optique de commande**
Halbleiterlaser mit optischem Steuereingang
Semi-conductor laser with optical command input

(30) Priorité: 27.12.1991 FR 9116238
(43) Date de publication de la demande: 30.06.1993
(73) Titulaire: ALCATEL CIT, F-75008 Paris (FR)
(72) Inventeur: Gabriagues, Jean-Michel, F-91530 Le Val Saint-Germain (FR); Le Roy, Guy, F-22300 Lannion (FR)
(74) Mandataire: Sciaux, Edmond

(56) Documents cités:
- PATENT ABSTRACTS OF JAPAN vol. 12, no. 175 (P-707)25 Mai 1988;& JP-A-62 286 017
- PATENT ABSTRACTS OF JAPAN vol. 14, no. 178 (E-915)10 Avril 1990;& JP-A-02 031 480
- PATENT ABSTRACTS OF JAPAN vol. 15, no. 295 (E-1094)26 Juillet 1991;& JP-A-03 105 990
- IEEE JOURNAL OF QUANTUM ELECTRONICS. vol. 26, no. 8, Août 1990, NEW YORK US,pages 1376 - 1383;KANG-YIH LIOU ET AL.:'Y-junction power divider in InGaAsP-InP photonic integrated circuits'
- IEEE JOURNAL OF QUANTUM ELECTRONICS. vol. 11, no. 1, Janvier 1975, NEW YORK US pages 32 - 39 WILLIAM K. BURNS ET AL. 'Mode conversion in planar-dielectric separating waveguides'

## Description

La présente invention concerne un dispositif à laser semi-conducteur avec entrée optique de commande, comportant au moins une cavité laser ayant une zone d'amplification laser et une zone d'absorption saturable.

Des lasers semi-conducteurs à absorbeur saturable ont déjà fait l'objet de différentes publications. En particulier, un document intitulé "Analysis of a proposed bi-stable injection laser" de G.J. LASHER, Solid-State Electronics, Pergamon Press 1964, Volume 7, page 707, décrit un laser du type FABRY-PEROT comportant d'un côté d'un guide de lumière deux électrodes successives. L'une injecte un courant d'alimentation à travers une section d'amplification du guide de lumière, ce courant traversant une jonction semi-conductrice dans laquelle. ce guide est inséré. L'injection dans ce guide de porteurs de charge de type opposé permet de réaliser l'amplification nécessaire à l'établissement d'une oscillation lumineuse. L'autre électrode injecte un courant de commande d'absorbance dans un absorbeur saturable qui est constitué par une autre section de ce guide. La commande électrique de l'absorbance fait apparaître, sur le diagramme qui relie la puissance lumineuse émise par un tel laser à l'intensité du courant alimentant ce laser, un cycle d'hystérésis dont la largeur est liée à cette absorbance.

L'invention vise à fournir un dispositif utilisant des lasers de ce type qui soit doté d'une entrée optique de commande, permettant de déclencher l'oscillation laser par voie optique. L'invention se propose, plus particulièrement, de fournir un opérateur photonique bi-stable, un élément régénérateur optique et un ensemble d'éléments régénérateurs pouvant former un registre à décalage ou une ligne de retard optique à sorties multiples.

A cet effet, le dispositif selon l'invention, comme revendiqué dans la revendication 1, est caractérisé en ce que la cavité laser comprend un dispositif de couplage asymétrique, comportant un premier et un second guide de lumière ayant, pour la longueur d'onde d'émission laser de la cavité, des indices de réfraction effectifs différents, l'indice effectif dudit premier guide étant au moins proche de l'indice effectif des modes laser se propageant dans lesdites zone d'amplification et d'absorption, ledit second guide étant agencé pour pouvoir être couplé avec une source de signaux optiques de commande.

L'énergie optique de déclenchement est ainsi acheminée vers la cavité laser par un guide optique séparé selon une structure équivalant à un coupleur asymétrique séparateur de mode. De tels coupleurs sont connus en soi par l'article "Mode conversion in planar-dielectric separating waveguides" de William K. BURNS et A. FENNER MILTON, paru dans IEEE/Journal of Quantum Electronics, Volume QE-11, No 1, janvier 1975, pages 32 à 39. Un tel coupleur se comporte comme un séparateur de modes pour une onde optique se propageant dans la zone de couplage en direction des guides de lumière de sortie et permet, par un choix approprié des indices de réfraction effectifs, de diriger la quasi-totalité de l'énergie optique se propageant dans le mode fondamental, vers l'un des guides de sortie, l'énergie se propageant dans un mode d'ordre supérieur se retrouvant quasi intégralement dans l'autre guide.

L'invention utilise la combinaison d'un laser à absorbeur saturable et d'un coupleur asymétrique placé à une de ses extrémités pour réaliser un laser déclenchable optiquement.

Selon une forme d'exécution dans laquelle la cavité laser est constituée par un circuit intégré photonique et les zones d'amplifaction et d'absorption sont formées par des guides de lumière allongés, disposés dans le prolongement rectiligne l'un de l'autre, le premier guide du dispositif de couplage peut être aligné avec le guide de lumière des zones d'amplification et d'absorption, et la cavité laser peut comporter deux miroirs pour l'oscillation laser formés par des facettes respectives du circuit intégré disposées orthogonalement à la direction desdits guides alignés.

Alternativement, les premier et second guides de chaque dispositif de couplage peuvent être inclinés par rapport à la direction des zones d'amplification et d'absorption de la cavité laser, celles-ci ayant une face agencée comme premier miroir pour l'oscillation laser, un second miroir étant intégré entre ladite zone d'absorption et lesdits guides du dispositif de couplage.

Le dispositif selon l'invention peut comporter N cavités laser connectées optiquement en cascade, de façon que le premier guide du dispositif de couplage d'une cavité de rang n soit couplé avec le second guide du dispositif de couplage d'une cavité de rang n+1, le second guide de la cavité de rang 1 étant agencé pour être couplé avec une source d'un flux de signaux optiques du type série et chaque cavité laser ayant une face agencée pour servir de sortie optique intermédiaire du dispositif. Dans ce cas, les guides de chaque dispositif de couplage sont, de préférence, inclinés par rapport à la direction des zones d'amplification et d'absorption de la cavité laser correspondante et présentent, aux endroits du couplage entre eux, des caractéristiques opto-géométriques identiques. Lorsque les cavités laser et leurs dispositifs de couplage sont agencés de façon que le délai de propagation de la lumière d'une cavité à l'autre soit constant, on obtient ainsi un dispositif accordé pouvant servir de registre à décalage à entrée série et sortie parallèle ou comme ligne à retard à sorties multiples.

Physiquement, le fonctionnement d'un ensemble de N cavités laser en cascade suppose que les caractéristiques de commande optique de chaque laser soient compatibles avec les caractéristiques d'émission de chaque laser en régime d'oscillation. Pour cela, deux modes de réalisation sont envisagés :
- dans un premier mode de réalisation, les longueurs d'onde caractéristiques d'émission des lasers sont arrangées par construction de sorte que le laser de rang n (1<n<N) émette un rayonnement de longueur d'onde plus grande (ie des photons moins énergétiques) que celle du rayonnement optique délivré par le laser de rang N-1 et destiné à commander optiquement sa mise en oscillation.
- dans un second mode de réalisation, le guide qui permet de raccorder deux lasers consécutifs est doté de moyens d'amplification internes, procurés par pompage électrique ou optique du matériau semi-conducteur constitutif selon un état de l'art connu, de sorte à assurer que la puissance électrique de commande d'un laser est toujours supérieure ou égale à la puissance délivrée en régime d'oscillation.

Il est clair que l'un ou l'autre mode de réalisation permet de s'assurer que chaque laser de rang n ne pourra pas saturer l'absorption de sa propre zone d'absorbant saturable par l'effet du rayonnement qu'il émet, et que sa mise en oscillation sera conditionnée par la présence du pompage optique du laser de rang n-1.

D'autres caractéristiques et avantages de l'invention apparaîtront plus clairement à la lumière de la description de différentes formes de réalisation, indiquées ci-après à titre d'exemples et illustrées par les dessins annexés, dans lesquels:
La Fig. 1 représente une première forme d'exécution d'un laser déclenchable optiquement selon l'invention;
La Fig. 2 montre la relation entre un signal de commande et un signal émis pour un cycle d'hystérésis donné;
La Fig. 3 est une vue similaire à la Fig. 1 d'une autre forme de réalisation du dispositif de couplage d'un dispositif laser selon l'invention; et
La Fig. 4 montre l'application d'un dispositif selon la Fig. 3 pour la formation d'un registre à décalage accordé.

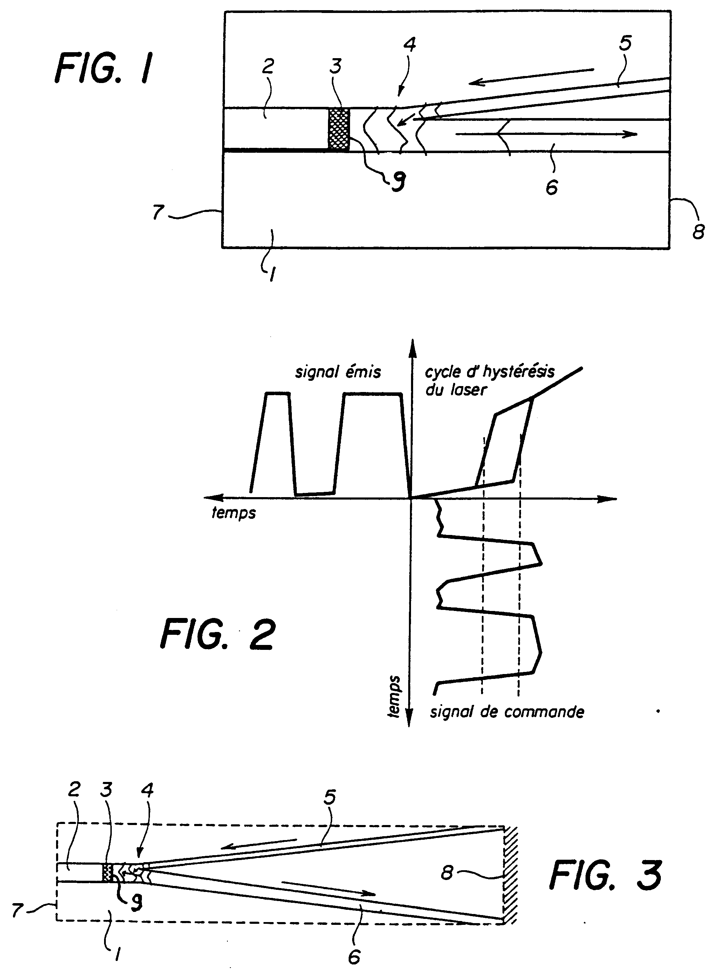

Le dispositif représenté à la Fig. 1 comporte un circuit intégré photonique réalisé sur un substrat semi-conducteur 1, par exemple en phosphure d'indium, portant une zone d'amplification laser 2 et une zone d'absorption saturable 3, ainsi qu'un dispositif de couplage 4 comprenant deux guides de lumière asymétriques 5 et 6. Les caractéristiques opto-géométriques des différentes zones du circuit intégré photonique sont choisies de telle sorte que l'indice de réfraction effectif du guide 6 pour la longueur d'onde d'émission laser du dispositif, est adapté à l'indice effectif du mode laser se propageant dans les zones 2 et 3. La cavité laser représentée à la Fig. 1 comporte : un miroir 7 constitué par une facette du circuit intégré photonique disposée orthogonalement à l'axe commun des guides 2, 3 et 6; et un miroir constitué par l'interface 9 entre la zone 3 et le dispositif de couplage 4.

En l'absence d'un signal optique d'un niveau de puissance suffisant dans le guide 5, qui constitue l'entrée optique de commande du dispositif, l'émission laser dans les guides 2 et 3 est bloquée moyennant un choix approprié des courants électriques de polarisation selon la technique connue. Lorsqu'un signal optique de puissance appropriée est couplé dans le guide 5, l'équilibre gain- perte de la cavité laser est atteint après un délai caractéristique des effets physiques mis en jeu. Le faisceau laser se propageant dans la zone 2 avec un indice effectif très voisin de celui de la zone 6, l'oscillation laser se déclenche dans la cavité composite 2, 3, 6, sans que le guide 5 ne collecte de lumière en quantité significative. La puissance laser est émise vers l'extérieur au niveau de la facette 7.

Un tel dispositif est caractérisé par un cycle d'hystérésis tel qu'il est représenté à la Fig. 2, et qui dépend des paramètres physiques du circuit et des conditions de polarisation de l'électrode de commande de la zone d'absorption saturable. Dans un mode de fonctionnement élémentaire, le dispositif émet un rayonnement laser tant que le signal optique de commande est disponible dans le guide 5. Selon un autre mode de fonctionnement, une impulsion lumineuse véhiculée par le guide 5 suffit à mettre en marche, durablement, l'oscillation laser. Dans ce dernier cas, l'extinction s'effectue par rupture de l'alimentation électrique de l'électrode de la zone d'amplification 2.

Dans le cas où le signal de commande optique est un signal modulé en tout ou rien, véhiculant un flux d'informations binaires codées, le présent dispositif se comporte comme un régénérateur optique. En effet, le dispositif, doté de caractéristiques de bande passante adaptées, émet un signal qui est une image du signal de commande après une remise en forme découlant de son cycle d'hystérésis propre, comme le montre la Fig. 2.

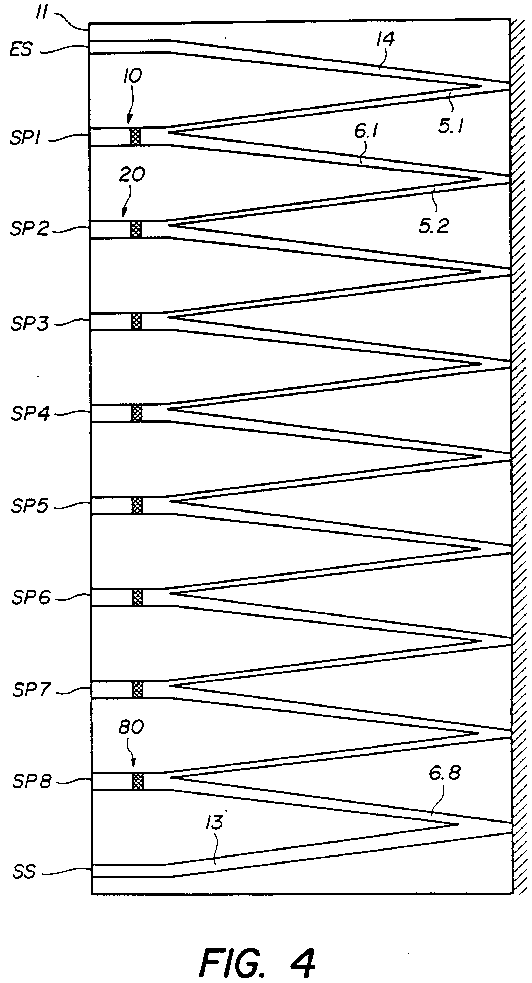

La Fig. 3 présente une structure modifiée par rapport à celle de la Fig. 1, en créant une seconde face réfléchissante 8, parallèle à la première face 7.

Les éléments analogues à ceux de la Fig. 1 ont été désignés par les mêmes chiffres de référence. Dans cette forme d'exécution, le guide de sortie 6 est incliné par rapport à l'axe des guides 2 et 3, de la même façon que le guide d'accès 5 de la zone de couplage. Les deux guides 5 et 6 présentent une variation régulière de leurs caractéristiques opto-géométriques, telles que la largeur du profil d'indice de guidage, de sorte qu'au niveau de la face 8 les deux guides ont des caractéristiques identiques. Par ailleurs, la face 8 est pourvue d'un traitement réflecteur d'efficacité proche de 100%.

On obtient ainsi un circuit constituant un motif utilisable en cascade, selon le schéma de la Fig. 4.

Sur la Fig. 4 on reconnaît huit dispositifs élémentaires tels que celui représenté à la Fig. 3, couplés entre eux de façon qu'un guide d'accès tel que 5.2 du dispositif de couplage d'une cavité laser telle que 20, soit couplé avec le guide de sortie 6.1 de la cavité précédente, en l'occurrence 10. La cavité 10 est couplée, par l'intermédiaire d'un guide d'accès 5.1, à un guide d'entrée 14 du dispositif. L'ensemble peut en outre être muni d'un guide de sortie 13, couplé avec le guide de sortie 6.8 du dispositif de couplage de la dernière cavité 80.

Les faces de chaque cavité laser situées dans le plan 11 sont conçues comme sorties intermédiaires SP1, SP2, ... SP80 du circuit global. Ce circuit peut être utilisé en couplant un signal lumineux modulé en tout ou rien et véhiculant des informations codées, à l'entrée ES du guide 14. Ce signal se propage dans les motifs périodiques du circuit, de façon qu'au niveau de chaque régénérateur, le signal reçu par le guide d'accès 5.n est ré-émis strictement dans les guides de sortie 6.n successifs. A condition que le délai de propagation de la lumière d'un régénérateur au suivant soit égal à la période des signaux binaires couplés à l'entrée ES, ce dispositif fonctionne comme un registre à décalage accordé pouvant servir de registre à entrée série et sortie parallèle, ou de ligne à retard à sorties multiples. On notera que le mode de réalisation particulier selon la Fig. 3 présente des sorties optiques perpendiculaires aux faces du circuit, ce qui est un avantage pour la connexion à une nappe de fibres optiques ou à une barette d'éléments opto-électroniques actifs.

## Revendications

1. Dispositif à laser semi-conducteur avec entrée optique de commande, comportant au moins une cavité laser (1) ayant une zone d'amplification laser (2) et une zone d'absorption saturable (3), caractérisé en ce qu'il comporte en outre un dispositif de couplage (4) asymétrique, séparateur de modes, placé à une extrémité de la cavité laser (1), et comportant un premier (6) et un second (5) guide de lumière ayant, pour la longueur d'onde d'émission laser de la cavité, des indices de réfraction effectifs différents, l'indice effectif dudit premier guide (6) étant adapté à l'indice effectif du mode laser se propageant dans lesdites zones d'amplification et d'absorption, ledit second guide (5) étant agencé pour pouvoir être couplé avec une source de signaux optiques de commande;
en ce que la zone d'amplification laser (2) et la zone d'absorption saturable (3) sont formées respectivement de deux guides de lumière allongés et disposés dans le prolongement rectiligne l'un de l'autre ;
et en ce que la zone d'absorption saturable (3) est couplée à une partie du dispositif de couplage (4) qui est commune au premier (6) et au second guide (5) de ce dispositif du couplage.

2. Dispositif selon la revendication 1, dans lequel les zones d'amplification (2) et d'absorption (3) sont formées par des guides de lumières allongés, disposées dans le prolongement rectiligne l'un de l'autre, caractérisé en ce que ledit premier guide (6) du dispositif de couplage est aligné avec le guide de lumière des zones d'amplification (2) et d'absorption (3), la cavité laser (1) comportant une face (7) agencée comme premier miroir, et l'interface (9) entre ladite zone d'absorption (3) et lesdits guides (5, 6) du dispositif de couplage, comme second miroir.

3. Dispositif selon la revendication 1, dans lequel les zones d'amplification (2) et d'absorption (3) sont formées par des guides de lumière allongés, disposés dans le prolongement rectiligne l'un de l'autre, caractérisé en ce que ledit premier guide (6) du dispositif de couplage est aligné avec le guide de lumière des zones d'amplification (2) et d'absorption (3), la cavité laser (1) comportant deux miroirs pour l'oscillation laser, formés par des facettes respectives (7,8), disposées orthogonalement à la direction desdits guides alignées.

4. Dispositif selon la revendication 1, dans lequel les zones d'amplification (2) et d'absorption (3) de la cavité laser sont formées par des guides de lumière respectifs allongés, disposés dans le prolongement rectiligne l'un de l'autre, caractérisé en ce que les premier (6) et second (5) guides du dispositif de couplage sont inclinés par rapport à la direction des zones d'amplification et d'absorption et en ce que la cavité laser comporte une face (7) agencée comme premier miroir et l'interface (9) entre ladite zone d'absorption (3) et lesdites guides (5, 6) du dispositif de couplage, comme second miroir.

5. Dispositif, caractérisé en ce qu'il comporte N dispositifs selon la revendication 4, reliés en cascade par des moyens de couplage (8), de façon que ledit premier guide (6.n) du dispositif de couplage asymétrique, séparateur de modes, d'une cavité de rang n soit couplé avec ledit second guide (5.n+1) du dispositif de couplage asymétrique, séparateur de modes, d'une cavité de rang n+1 ; le second guide (5.1) de la cavité de rang 1 étant agencé pour être couplé (par ES) avec une source d'un flux de signaux optiques du type série ; et chaque cavité laser ayant une face (SP1, SP2, ...) agencée pour servir de sortie optique intermédiaire du dispositif.

6. Dispositif selon la revendication 5, caractérisé en ce que les N cavités laser, les N dispositifs de couplage asymétriques, séparateurs de modes, et les moyens de couplage en cascade sont agencés de façon que le délai de propagation de la lumière d'une cavité à l'autre soit constant.

## Patentansprüche

1. Halbleiterlaservorrichtung mit einem optischen Steuereingang, die mindestens einen Laserhohlraum (1) mit einer Laserverstärkungszone (2) und einer sättigungsfähigen Absorptionszone (3) enthält, dadurch gekennzeichnet, daß die Vorrichtung weiter eine asymmetrische Kopplungsvorrichtung (4), die als Mode-Separator wirkt und an einem Ende des Laserhohlraums (1) liegt, sowie einen ersten (6) und einen zweiten Lichtleiter (5) besitzt, deren wirksame Brechungsindices für die Laseremissionswellenlänge des Hohlraums unterschiedlich sind, wobei der effektiv Brechungsindex des ersten Lichtleiters (6) an den effektiven Brechungsindex de Schwingungsmodus angepaßt ist, der sich in der Verstärkungs- und der Absorptionszone ausbreitet, wobei der zweite Lichtleiter (5) mit der optischen Steuersignalquelle gekoppelt werden kann,
daß die Laserverstärkungszone (2) und die sättigungsfähige Absorptionszone (3) aus zwei länglichen Lichtleitern bestehen, die geradlinig hintereinander liegen,
und daß die sättigungsfähige Absorptionszone (3) an einen Teil der Kopplungsvorrichtung (4) gekoppelt ist, der sowohl zum ersten (6) als auch zum zweiten Lichtleiter (5) dieser Kopplungsvorrichtung gehört.

2. Vorrichtung nach Anspruch 1, in der die Verstärkungs- und die Absorptionszone (2, 3) aus länglichen Lichtleitern gebildet werden, die in geradliniger Flucht hintereinander liegen, dadurch gekennzeichnet, daß der erste Lichtleiter (6) der Kopplungsvorrichtung mit dem Lichtleiter der Verstärkungs - und Absorptionszonen (2, 3) fluchtet und daß der Laserhohlraum (1) eine als erster Spiegel ausgebildete Stirnseite (7) sowie einen Übergang (9) in Form eines zweiten Spiegels zwischen der Absorptionszone (3) und den Lichtleitern (5, 6) der Kopplungsvorrichtung aufweist.

3. Vorrichtung nach Anspruch 1, in der die Verstärkungs- und die Absorptionszone (2, 3) aus länglichen Lichtleitern gebildet werden, die in geradliniger Flucht zueinander liegen, dadurch gekennzeichnet, daß der erste Lichtleiter (6) der Kopplungsvorrichtung mit dem Lichtleiter der Verstärkungs- und der Absorptionszone (2, 3) fluchtet und daß der Laserhohlraum (1) zwei Spiegel für die Laserschwingung aufweist, die von Spaltflächen (7, 8) gebildet werden, welche senkrecht zur Richtung der fluchtenden Lichtleiter verlaufen.

4. Vorrichtung nach Anspruch 1, in der die Verstärkungs- und die Absorptionszone (2, 3) aus länglichen Lichtleitern gebildet werden, die in geradliniger Flucht zueinander liegen, dadurch gekennzeichnet, daß der erste (6) und der zweite Lichtleiter (5) der Kopplungsvorrichtung bezüglich der Richtung der Verstärkungs- und der Absorptionszone geneigt verlaufen und daß der Laserhohlraum eine als erster Spiegel ausgebildete Stirnseite (7) und einen als zweiter Spiegel wirksamen Übergang (9) zwischen der Absorptionszone (3) und den Lichtleitern (5, 6) der Kopplungsvorrichtung aufweist.

5. Vorrichtung, dadurch gekennzeichnet, daß sie N Vorrichtungen nach Anspruch 4 enthält, die in Kaskade über Kopplungsmittel (8) derart miteinander verbunden sind, daß der erste Lichtleiter (6,n) der als Mode-Separator wirkenden unsymmetrischen Kopplungsvorrichtung eines Hohlraums des Rangs n mit dem zweiten Lichtleiter (5.n+1) der als Mode-Separator wirkenden unsymmetrischen Kopplungsvorrichtung eines Hohlraums des Rangs n+1 gekoppelt ist, wobei der zweite Lichtleiter (5.1) des Hohlraums des Rangs 1 (über ES) mit einer Quelle eines optischen Seriendatenflusses gekoppelt ist und jeder Laserhohlraum eine Stirnseite (SP1, SP2, ...) aufweist, die als optischer Zwischenausgang der Vorrichtung dient.

6. Vorrichtung nach Anspruch 5, dadurch gekennzeichnet, daß die N Laserhohlräume, die N als Mode-Separatoren wirkenden unsymmetrischen Kopplungsvorrichtungen und die Kopplungsmittel für die Kaskadenschaltung so gestaltet sind, daß die Laufzeit der Lichtausbreitung von einem Hohlraum zum nächsten konstant ist.

## Claims

1. Semiconductor laser device having an optical control input and including at least one laser cavity (1) having a laser amplification area (2) and a saturable absorption area (3), characterised in that it further includes an asymmetric mode separator coupling device (4) at one end of the laser cavity (1) and including first and second optical waveguides (6, 5) having different effective refractive indices at the laser emission wavelength of the cavity, the effective index of said first waveguide (6) being matched to the effective index of the laser mode propagating in said amplification and absorption areas, said second waveguide (5) being adapted to be coupled to a source of optical control signals;
in that the laser amplification area (2) and the saturable absorption area (3) are respectively formed by two elongate optical waveguides disposed in rectilinear alignment with each other;
and in that the saturable absorption area (3) is coupled to a part of the coupling device (4) which is common to the first and second waveguides (6, 5) of the coupling device.

2. Device according to claim 1 wherein the amplification and absorption areas (2, 3) are formed by elongate optical waveguides disposed in rectilinear alignment with each other, characterised in that said first waveguide (6) of the coupling device is aligned with the optical waveguide of the amplification and absorption areas (2, 3), the laser cavity (1) having one face (7) adapted to constitute a first mirror and the interface (9) between said absorption area (3) and said waveguide (5, 6) of the coupling device constituting a second mirror.

3. Device according to claim 1 wherein the amplification and absorption areas (2, 3) are formed by elongate optical waveguides disposed in rectilinear alignment with each other, characterised in that said first guide (6) of the coupling device is aligned with the optical waveguide of the amplification and absorption areas (2, 3), the laser cavity (1) including two mirrors for the laser oscillation formed by respective facets (7, 8) orthogonal to the direction of said aligned waveguides.

4. Device according to claim 1 wherein the amplification and absorption areas (2, 3) of the laser cavity are formed by respective elongate optical waveguides disposed in rectilinear alignment with each other, characterised in that the first and second waveguides (6, 5) of the coupling device are inclined to the direction of the amplification and absorption areas and in that the laser cavity includes one face (7) adapted to constitute a first mirror and the interface (9) between said absorption area (3) and said waveguides (5, 6) of the coupling device constituting a second mirror.

5. Device characterised in that it includes N devices according to claim 4 connected in cascade by coupling means (8) so that said first waveguide (6.n) of the asymmetric mode separator coupling device of cavity n is coupled to said second waveguide (5.n+1) of the asymmetric mode separator coupling device of cavity n+1; the second waveguide (5.1) of cavity 1 being adapted to be coupled (via ES) with a source of a stream of series type optical signals; and each laser cavity having one face (SP1, SP2, ...) adapted to provide an intermediate optical output of the device.

6. Device according to claim 5 characterised in that the N laser cavities, the N asymmetric mode separator coupling devices and the cascade coupling means are adapted so that the propagation delay of light from one cavity to the other is constant.
